# EUROPÄISCHE PATENTANMELDUNG

(11) **EP 0 881 664 A2**
(43) Veröffentlichungstag der Anmeldung: **02.12.1998**
(21) Anmeldenummer: 98890155.9
(22) Anmeldetag: 22.05.1998
(51) Int. Cl.: H01L 21/00

(54) **Anordnung zum Behandeln scheibenförmiger Gegenstände, insbesondere Siliziumwafer**

(30) Priorität: 23.05.1997 AT 886/97
(71) Anmelder: SEZ Semiconductor-Equipment Zubehör für die Halbleiterfertigung AG, 9500 Villach (AT)
(72) Erfinder: Wagner, Gerald, Dr.tech. Dipl.-Ing., 9220 Velden (AT); Frey, Helmut, Ing., 9170 Ferlach (AT)
(74) Vertreter: Beer, Manfred, Dipl.-Ing.

(57) **Zusammenfassung**

Um nach dem Behandeln scheibenförmiger Gegenstände (2), vornehmlich Siliziumwafer, mit einem Behandlungsmedium, vorzugsweise mit einem Ätzfluid, auf der Unterseite des scheibenförmigen Gegenstandes (2), d.i. die dem Träger (1) für den scheibenförmigen Gegenstand (2) zugekehrte Seite, in deren Randbereich anhaftende Reste von Behandlungsmedium zu entfernen, ist eine Düse (20) vorgesehen, aus der eineSpülflüssigkeit, vorzugsweise deionisiertes Wasser, auf den Außenrand des Gegenstandes (2) und zwischen den Träger (1) und den scheibenförmigen Gegenstand (2) eingespritzt werden kann. Die abhängig vom Druck, mit dem die Spülflüssigkeit aus der Düse (20) austritt und der Ausrichtung der Düse (20) gegenüber dem scheibenförmigen Gegenstand (2) mehr oder weniger weit eindringende Spülflüssigkeit wird durch das Drehen des scheibenförmigen Gegenstandes (2) wieder abgeschleudert und nimmt dabei Reste an Behandlungsmedium mit. Für eine optimale Wirkung kann die Ausrichtung der Düse (20) gegenüber dem Rand (16) des scheibenförmigen Gegenstandes (2) verändert werden.

## Beschreibung

Die Erfindung betrifft eine Anordnung mit den Merkmalen des einleitenden Teils des Anspruches 1.

Scheibenförmige Gegenstände, vornehmlich Siliziumwafer, werden bei ihrer Behandlung, z.B. beim Ätzen, auf Trägern gehalten und durch diese Träger in Drehung versetzt, während mit einem Ätzmedium behandelt wird. Nach dem Ätzen wird mit einer Spülflüssigkeit, z.B. Wasser, gespült, um das Ätzmedium zu entfernen.

Es hat sich herausgestellt, daß insbesondere in dem Bereich des Außenrandes der dem Träger zugekehrten Seite des scheibenförmigen Gegenstandes auch nach dem Spülen mit einer Spülflüssigkeit, insbesondere (deionisiertes) Wasser, das auf die vom Träger abgewendete (Ober-)Seite auf den Gegenstand aufgebracht wird, noch Säurereste verbleiben, was unerwünscht ist.

Eine Anordnung mit den Merkmalen des einleitenden Teils von Patentanspruch 1 ist aus der EP 753 884 A und aus der WO 96/35227 bekannt. Mit den Düsen für Spülflüssigkeit der bekannten Anordnungen kann aber nur die vom Träger abgewendete (nach oben weisende) Seite eines scheibenförmigen Gegenstandes gespült werden. Das Problem von auf der zum Träger hin weisenden (Unter-)Seite des Gegenstandes verbleibenden Reste von Ätzmedien wird mit den bekannten Anordnungen nicht gelöst.

Der Erfindung liegt die Aufgabe zu Grunde, eine Anordnung der eingangs genannten Gattung zur Verfügung zu stellen, mit der Säurereste auch im Bereich des Randes des scheibenförmigen Gegenstandes auf seiner dem Träger zugekehrten Seite zuverlässig entfernt werden können.

Gelöst wird diese Aufgabe mit einer Anordnung mit den Merkmalen des kennzeichnenden Teils von Anspruch 1.

Mit der erfindungsgemäßen Anordnung wird der scheibenförmige Gegenstand, vorzugsweise der Siliziumwafer, nach dem Ätzen und Unterätzen (Ätzen im Bereich des Außenrandes der dem Träger zugewendeten Seite) im Randbereich mit aus der Düse austretender Spülflüssigkeit, vorzugsweise deionisiertem Wasser, bespritzt. Je nach Ausrichtung der Düse bzw. Druck des Spülmittelstrahles kann die Spülflüssigkeit mehr oder weniger weit zwischen den scheibenförmigen Gegenstand und den Träger eindringen und wird kurz darauf wegen der Drehung des Gegenstandes wieder abgeschleudert und nimmt dabei Säurereste mit.

Bevorzugte und vorteilhafte Ausgestaltungen der erfindungsgemäßen Anordnung sind Gegenstand der Unteransprüche.

Weitere Einzelheiten, Merkmale und Vorteile der erfindungsgemäßen Anordnung ergeben sich aus der nachstehenden Beschreibung des in der Zeichnung schematisch wiedergegebenen Ausführungsbeispiels.

Es zeigt:
Fig. 1 in Draufsicht einen Träger mit einem auf ihm angeordneten, scheibenförmigen Gegenstand und mit einer Düse für Spülflüssigkeit,
Fig. 2 in Seitenansicht einen Träger mit einem auf ihm angeordneten, scheibenförmigen Gegenstand und der Düse von Fig. 1 und
Fig. 3 in vergrößerter Darstellung eine Einzelheit von Fig. 2.

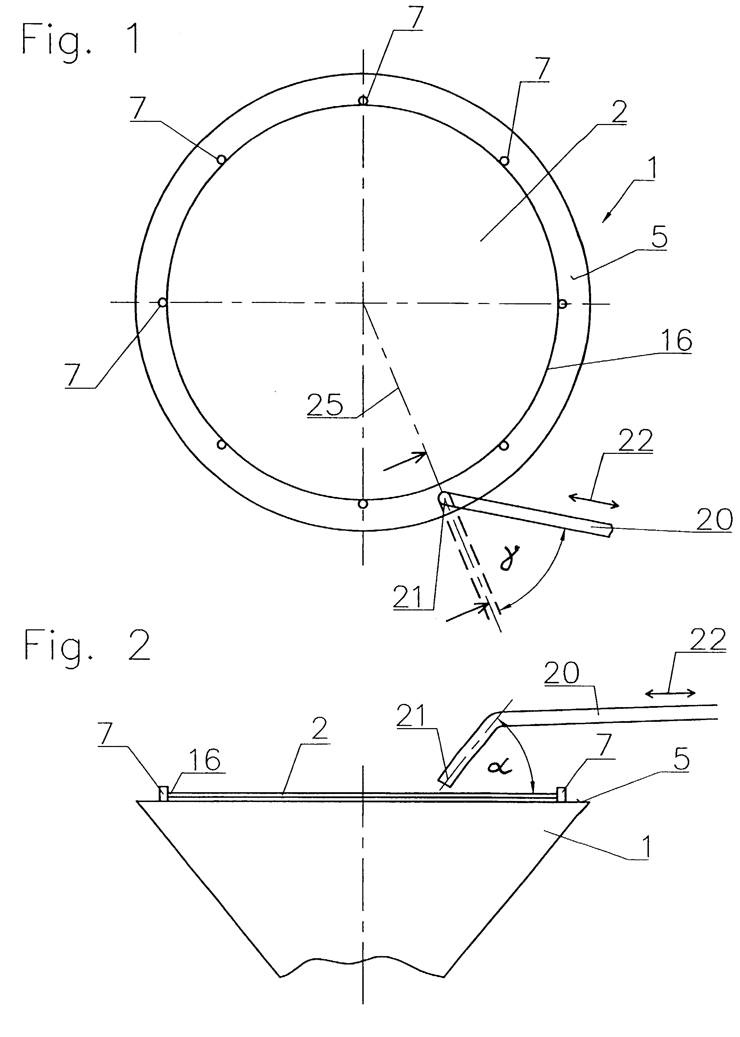

Wie in Fig. 1 gezeigt, ist einem Träger 1, auf dem ein Gegenstand 2 gehalten wird, eine Düse 20 zugeordnet, deren Mündung 21 durch Verstellen der Düse 20 in Richtung des Doppelpfeiles 22 neben dem Außenrand 16 des scheibenförmigen Gegenstandes 2 angeordnet werden kann. Der Gegenstand 2, z.B. ein (Silizium)Wafer, wird am Träger 1 entweder durch das Bernoulli-Prinzip festgehalten und seitlich durch Zapfen 7 gestützt, oder durch Unterdruck festgehalten. Dem Träger 1 kann ein Dreh-Antrieb zugeordnet sein, so daß der Gegenstand 2 beim Behandeln gedreht werden kann.

Aus der Düse 20 aufgebrachte Spülflüssigkeit, z.B. deionisiertes Wasser, trifft auf dem Außenrand des Gegenstandes 2 und auf die nach oben weisende Fläche 5 des Trägers 1 und dringt zwischen den scheibenförmigen Gegenstand 2 und die diesem zugekehrte Fläche 5 des Trägers 1 ein. Das Ausmaß des Eindringens von Spülflüssigkeit hängt von dem Druck ab, mit dem Spülflüssigkeit aus der Düse 20 austritt und kann zusätzlich durch Verändern des Winkels γ, den die Achse der Düse 20 bzw. ihrer Mündung 21 mit einer Radialebene 25 einschließt, eingestellt werden. Überdies ist für das Ausmaß des Eindringens von Spülflüssigkeit auch der Winkel α zwischen der Achse der Mündung 21 der Düse 20, also dem Spülflüssigkeitsstrahl und der Fläche 5 des Trägers 1 maßgeblich.

Mit der in den Fig. 1 und 2 dargestellten, dem Träger 1 zugeordneten Düse 20 kann, nachdem der scheibenförmige Gegenstand 2 (z.B. ein Siliziumwafer) auch in seinem Randbereich auf seiner dem Träger 1 zugewendeten Unterseite geätzt wurde (Unterätzen) zuverlässig dafür gesorgt werden, daß mit dem Spülen durch auf die Oberseite (vom Träger 1 abgekehrte Seite) des Gegenstandes 2 aufgebrachtes Spülmedium in dessen Randbereich der Unterseite, im Bereich der Unterätzung verbleibende Säurereste wirksam entfernt werden. Zusätzlich kann die Düse 20 während aus ihr Spülflüssigkeit ausgespritzt wird, beispielsweise auch in Richtung des Doppelpfeiles 22 oszillierende Bewegungen ausführen, um die Spülwirkung zu verbessern. Auch der Winkel γ, den die Düse 20 und die Achse ihrer Mündung 21 mit einer Radialebene 25 einschließt, und/oder der Winkel α, den die Achse der Düsenmündung 21 mit der Ebene des Gegenstandes 2 einschließt, kann verändert werden, um optimale Ergebnisse zu erzielen. Eine einmal gewählte Einstellung der Winkel α und γ kann beibehalten oder während eines Spülvorganges (periodisch) verändert werden.

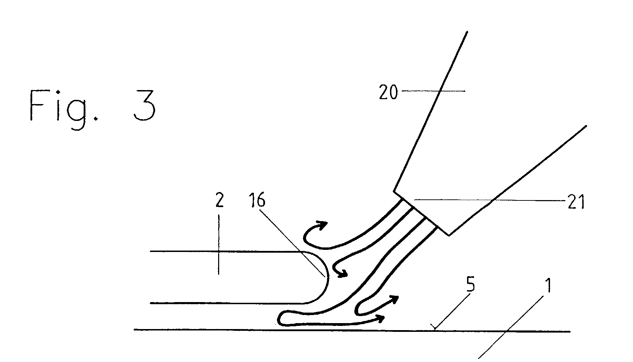

Die aus der Düse 20 aufgebrachte Spülflüssigkeit, vorzugsweise deionisiertes Wasser, dringt wie oben beschrieben, je nach dem Druck der Spülflüssigkeit und der Ausrichtung der Düse 20 mehr oder weniger weit zwischen den Gegenstand 2 und die ihm zugekehrte Fläche 5 des Trägers 1 ein und wird, bedingt durch das Drehen des Trägers 1 und damit des Gegenstandes 2, um die Achse des Trägers 1, wieder abgeschleudert, wobei sie an der Unterseite des scheibenförmigen Gegenstandes 2 allenfalls noch anhaftendes Ätzmedium mitnimmt. Dies ist in Fig. 3 schematisch dargestellt. Fig. 3 zeigt auch, daß die aus der Düse 20 austretende Spülflüssigkeit auch den Außenrand der Oberseite des Gegenstandes 2 spült, also nicht nur (begrenzt) zwischen dem Gegenstand 2 und dem Träger 1 eindringt.

Ein bevorzugtes Ausführungsbeispiel der erfindungsgemäßen Anordnung kann wie folgt beschrieben werden:

Um nach dem Behandeln scheibenförmiger Gegenstände 2, vornehmlich Siliziumwafer, mit einem Behandlungsmedium, vorzugsweise mit einem Ätzfluid, auf der Unterseite des scheibenförmigen Gegenstandes 2, d.i. die dem Träger 1 für den scheibenförmigen Gegenstand 2 zugekehrte Seite, in deren Randbereich anhaftende Reste von Behandlungsmedium zu entfernen, ist eine Düse 20 vorgesehen, aus der eine Spülflüssigkeit, vorzugsweise deionisiertes Wasser, auf den Außenrand des Gegenstandes 2 und zwischen den Träger 1 und den scheibenförmigen Gegenstand 2 eingespritzt werden kann. Die abhängig vom Druck, mit dem die Spülflüssigkeit aus der Düse 20 austritt und der Ausrichtung der Düse 20 gegenüber dem scheibenförmigen Gegenstand 2 mehr oder weniger weit eindringende Spülflüssigkeit wird durch das Drehen des scheibenförmigen Gegenstandes 2 wieder abgeschleudert und nimmt dabei Reste an Behandlungsmedium mit. Für eine optimale Wirkung kann die Ausrichtung der Düse 20 gegenüber dem Rand 16 des scheibenförmigen Gegenstandes 2 verändert werden.

## Patentansprüche

1. Anordnung zum Behandeln scheibenförmiger Gegenstände (2), insbesondere von Siliziumwafern, mit einem Träger (1), der um seine Achse gemeinsam mit dem an ihm gehaltenen Gegenstand (2) drehbar ist, und mit einer oberhalb der Ebene der dem Gegenstand (2) zugekehrten Fläche (5) des Trägers (1) angeordneten Düse (20) für Spülflüssigkeit, die zu dieser Ebene geneigt ist, dadurch gekennzeichnet, daß die Achse der Mündung (21) der Düse (20) auf den Randbereich des scheibenförmigen Gegenstandes (2) gerichtet ist, um aus der Düse Spülflüssigkeit auf den Randbereich der Oberseite des scheibenförmigen Gegenstandes (2) und zwischen die dem Gegenstand (2) zugekehrte Fläche (5) des Trägers (1) und dem Randbereich der Unterseite des Gegenstandes (2) zu spritzen.

2. Anordnung nach Anspruch 1, dadurch gekennzeichnet, daß die Düse (20) relativ zum Träger (1) verstellbar ist.

3. Anordnung nach Anspruch 2, dadurch gekennzeichnet, daß die Düse (20) in ihrer Längsrichtung (Pfeil 22) beweglich gehalten ist.

4. Anordnung nach einem der Ansprüche 1 bis 3, dadurch gekennzeichnet, daß die Düse (20) schwenkbar gehalten ist.

5. Anordnung nach einem der Ansprüche 1 bis 4, dadurch gekennzeichnet, daß die Düse (20) aus einer Stellung, in der sie in einer Radialebene (25), die durch die Achse des Trägers (1) geht, liegt, bis in eine zum Rand (16) des scheibenförmigen Gegenstandes (2) angenähert tangentiale Lage verschwenkbar ist.

6. Anodnung nach einem der Ansprüche 1 bis 5, dadurch gekennzeichnet, daß die Mündung (21) der Düse (20) in ihrer dem Rand (16) des scheibenförmigen Gegenstandes (2) zugeordneten Stellung unmittelbar neben dem Rand (16) des scheibenförmigen Gegenstandes (2) angeordnet ist.

7. Anordnung nach einem der Ansprüche 1 bis 6, dadurch gekennzeichnet, daß die Achse der Mündung (21) der Düse (20) mit der dem Gegenstand (2) zugekehrten Fläche (5) des Trägers (1) einen spitzen Winkel (α) einschließt.

8. Anordnung nach einem der Ansprüche 1 bis 7, dadurch gekennzeichnet, daß die Achse der Mündung (21) der Düse (20) mit einer durch die Mündung (21) der Düse (20) und die Achse des Trägers (1)gehenden Radialebene (25) einen spitzen Winkel (γ) einschließt.
